# EUROPEAN PATENT SPECIFICATION

(11) **EP 2 180 522 B1**
(45) Date of publication and mention of the grant of the patent: **07.02.2018**
(21) Application number: 08791935.3
(22) Date of filing: 30.07.2008
(51) Int. Cl.: H01L 31/042, H01L 31/04, H01L 31/0224, H01L 31/05

(54) **SOLAR CELL MODULE**
SOLARZELLENMODUL
MODULE DE CELLULE SOLAIRE

(30) Priority: 30.07.2007 JP 2007196946
(43) Date of publication of application: 28.04.2010
(73) Proprietor: Kyocera Corporation, Kyoto-shi Kyoto 612-8501 (JP)
(72) Inventor: MIYAKE, Takafumi, Ise-city, Mie 516-8510 (JP); OSAWA, Hidenao, Ise-city, Mie 516-8510 (JP); NIWA, Tetsuo, Higashiomi-shi, Shiga 527-8555 (JP)
(74) Representative: Viering, Jentschura & Partner mbB Patent- und Rechtsanwälte
(86) International application number: PCT/JP2008/063704
(87) International publication number: WO 2009/017174

(56) References cited:
- WO-A1-2007/043428
- WO-A1-2007/060743
- JP-A- H10 144 943
- JP-A- H11 214 733
- JP-A- 2000 164 901
- JP-A- 2002 111 024
- JP-A- 2002 359 388
- JP-A- 2003 224 289
- JP-A- 2004 281 800
- JP-A- 2005 159 173
- JP-A- 2005 217 131
- JP-A- 2006 210 654
- US-A- 5 279 682

## Description

The present invention relates to a solar cell module.

In recent years, the demand for a solar cell for domestic use tends to markedly increase in terms of environmental protection. A solar cell element is manufactured by preparing a first conductivity type semiconductor substrate and diffusing impurities of a second conductivity type which is different from the above substrate to form a pn junction.

These solar cell elements include a first electrode and a second electrode formed by applying materials composed of mainly metal on the front surfaces and back surfaces and firing (for example, Japanese Patent Application Laid-Open No. 2006-210654, Japanese Patent Application Laid-Open No. 2003-273377, and Japanese Patent Application Laid-Open No. 10-144943).

In general, a solar cell module configured such that a plurality of solar cell elements are connected to extract electric output, is used. This solar cell module generally has the configuration of connecting the first electrode to the second electrode of the plurality of the solar cell elements with an inner lead (tab) and covering first surfaces of the plurality of the connected solar cell elements with a translucent member and second surfaces with a colored member.

However, along with reduction in thickness of a substrate, when manufacturing, storing, transporting the solar cell module, the electrodes expand or contract due to the influence of heat and the like, cracks are easily generated on a surface of the substrate because of the influence of thermal stress. For instance, when the inner lead is connected to the second electrode by soldering, the substrate receives stress, the surface of the substrate located near the first electrode may be easily chipped. Particularly, when a lead-free solder such as Sn-Ag is used, the influence of the stress due to heat is increased since a melting point of the solder becomes high, and the surface of the substrate is easily chipped. Specifically, chips are caused at a boundary of the first electrode.

From JP 10144943 A a solar cell and a corresponding manufacturing method is known, wherein an aluminum paste is screen printed on the underside of a substrate to form a p⁺ layer and an aluminum electrode. Such a solar cell is provided with a silver electrode for taking out the output, and the silver electrode for taking out the output contains a fine wire portion comprising a plurality of thin wires. The thin wire portion is so constituted that it is sandwiched between the underside of the substrate and the aluminum electrode and is superposed on the aluminum electrode.

The present invention has been made to solve the above problem, and has an object of providing a solar cell module in which cracks are less likely difficult to be generated in a substrate.

In order to solve the above problem, the present invention provides a solar cell module according to claim 1. Further advantageous embodiments of the present invention are disclosed in the dependent claims.

Accordingly, the stress applied to the substrate located near the first electrode can be reduced. Thus, chips of a surface part of the substrate are reduced, thereby improving the reliability of the solar cell module.

The other objects, features, aspects and advantages of the present invention become more apparent from the following detailed description of the present invention when taken in conjunction with the accompanying drawings.

### Brief Description of Drawings

[FIG. 1] is a schematic view of a sectional structure showing one example of a solar cell element used for a solar cell module according to a first preferred embodiment of the present invention.
[FIG. 2] is a view showing one example of a configuration of an electrode at a side of receiving a light (front surface) of the solar cell element used for the solar cell module same as above.
[FIG. 3] is a view showing one example of a configuration of an electrode at a side of not receiving a light (back surface) of the solar cell element used for the solar cell module same as above.
[FIG. 4] is a sectional diagram showing the solar cell module same as above.
[FIG. 5] is an enlarged view showing one example of a second electrode of the solar cell element used for the solar cell module same as above.
[FIG. 6] is a sectional view, taken along a line X-X' of FIG. 5.
[FIG. 7] is another sectional view, taken along the line X-X' of FIG. 5.
[FIG. 8] is a view of simulating a maximum principal stress applied on a substrate of an edge part of a first electrode when a length D of a first opening and intervals E of a plurality of first openings are changed.
[FIG. 9] is an enlarged view showing another example of the second electrode of the solar cell element used for the solar cell module according to the first preferred embodiment.
[FIG. 10] is a view seen from below showing another example of the second electrode of the solar cell element used for the solar cell module same as above.
[FIG. 11] is an enlarged view showing another example of the second electrode of the solar cell element used for the solar cell module same as above.
[FIG. 12] is an enlarged view showing another example of the second electrode of the solar cell element used for the solar cell module same as above.
[FIG. 13] is a view showing a variation relating to an inner lead.
[FIG. 14] is a schematic view showing a part of surface side of not receiving a light (back surface) of the solar cell module according to the second preferred embodiment of the present invention.
[FIG. 15] is a partially enlarged view of FIG. 14.
[FIG. 16] is a view showing another example of a configuration of an electrode at a surface side of not receiving a light (back surface) of the solar cell element used for the solar cell module according to the first preferred embodiment of the present invention.
[FIG. 17] is a view showing another example of a configuration of an electrode at a surface side of not receiving a light (back surface) of the solar cell element used for the solar cell module according to the first preferred embodiment of the present invention.

Best Mode for Carrying Out the Invention

### <First Embodiment>

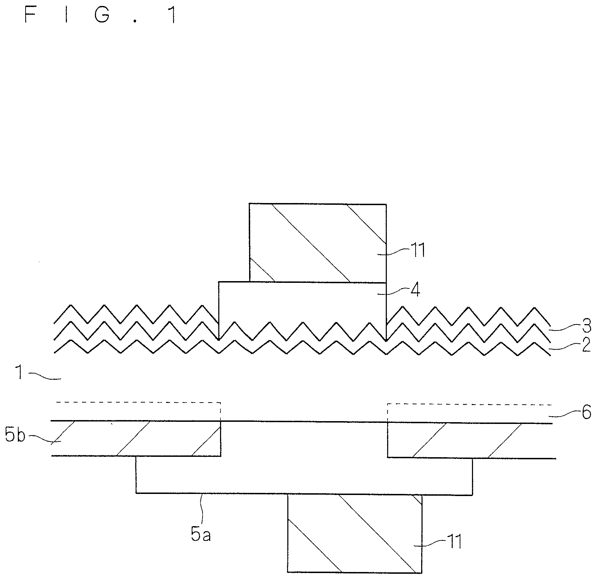

Hereinafter, a solar cell module according to a first embodiment will be described, referring to FIGS. 1 to 3.

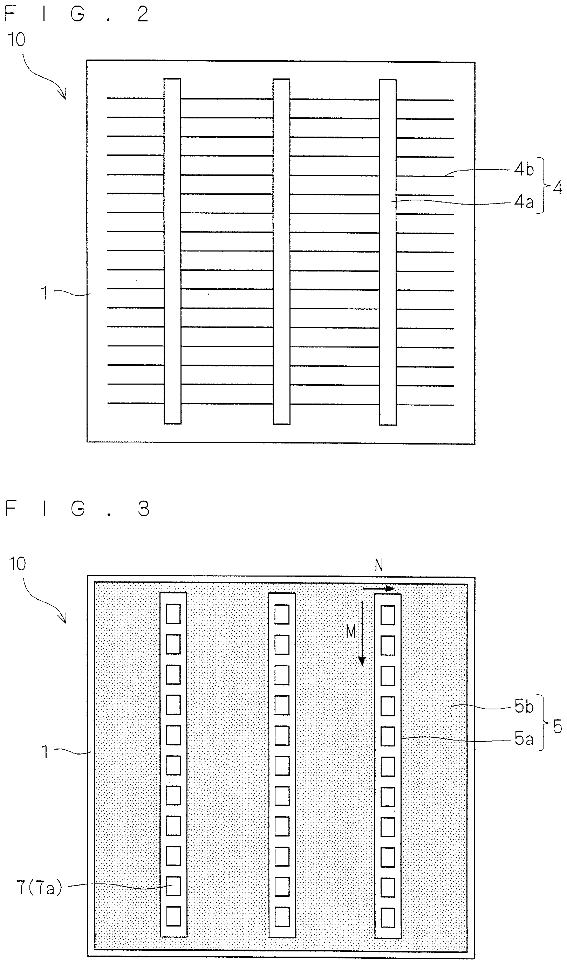

FIG. 1 is a schematic view of a sectional structure showing one example of a solar cell element used for the solar cell module according to the first embodiment of the present invention. FIG. 2 is a view (seen from above) showing one example of a configuration of an electrode at a side of receiving a light (front surface) of the solar cell element used for the solar cell module of the present embodiment. FIG. 3 is a view (seen from below) showing one example of a configuration of an electrode at a side of not receiving a light (back surface) of the solar cell element used for the solar cell module of the preferred embodiment.

The solar cell module according to the present embodiment includes a plurality of solar cell elements including a substrate 1 including a first surface (an upper surface in FIG. 1) to which a light enters and a second surface (a lower surface in FIG. 1) disposed at an opposite side of the first surface, a first electrode 4 provided on the first surface of the substrate 1 and a second electrode 5 provided on the second surface of the substrate 1 and including an output extraction portion 5a with a first opening 7a, and a plurality of inner leads 11 as a first inner lead connecting adjacent solar cell elements.

A diffusion layer 2 is formed at a side of the first surface of the substrate 1, and a back surface field region (BSF) 6 is formed at a side of the second surface of the substrate 1. Also, an antireflective film 3 is disposed on the first surface of the substrate 1. Such a substrate 1 is composed of, for example, monocrystalline or polycrystalline silicon, and includes semiconductor impurities having p-type conductivity such as boron (B).

The diffusion layer 2 is formed in the substrate 1. When the substrate 1 is a p-type silicon substrate, a pn junction is formed between a p-type bulk region and the diffusion layer 2. As an n-type doping element, for example, phosphorus (P) is used.

The antireflective film 3 serves to reduce reflectance of a light with a predetermined wavelength domain and increase photoproduction carrier amount so as to improve photocurrent density Jsc of a solar cell element 10. The antireflective film 3 is composed of, for example, an SiNx film (having composition variation centering on Si₃N₄ stoichiometry), a TiO₂ film, a SiO₂ film, an MgO film, an ITO film, an SnO₂ film, ZnO film, or the like. The thickness is appropriately selected for each material, making difficult to reflect for an arbitrary incident light. For example, when the substrate 1 is composed of silicon, preferably, a refractive index is approximately from 1.8 to 2.3, and a thickness is approximately from 500 to 1200 Å.

In FIG. 1, the BSF region 6 is a p⁺ region in a surface part of the second surface side of the substrate 1. The BSF region 6 serves to reduce the decrease in efficiency caused by recombination of carriers near the second surface of the substrate 1 and to form an inner electric field at the second surface side of the substrate 1.

The first electrode 4 includes a first output extraction portion (bus bar electrode) 4a and a first power collection portion (finger electrode) 4b. At least a part of the first output extraction portion 4a intersects the first power collection portion 4b. The first electrode 4 of the present embodiment includes the first output extraction portion 4a which is wide to be approximately from 1.3 mm to 2.5 mm, and the first power collection unit 4b provided perpendicularly to the first output extraction portion 4a, which is narrow to be approximately from 50 to 200 µm. The thickness of this first electrode 4 (first output extraction portion 4a, first power collection unit 4b) is approximately from 10 to 40 µm.

The second electrode 5 includes a second output extraction portion 5a and a second power collection unit 5b. The thickness of the second output extraction portion 5a of the present embodiment is approximately from 10 µm to 30 µm, the width thereof is approximately from 3.5 mm to 7 mm. The thickness of the second power collection unit 5b is approximately from 15 µm to 50 µm.

These first power collection unit 4b and second power collection unit 5b serve to collect power of carriers generated mainly in the substrate 1, and the first output extraction portion 4a and the second output extraction portion 5a serve to collect the carriers collected in the first and second power collection units 4b, 5b and to output. The first electrode 4 (first output extraction portion 4a) and the second electrode 5 (second output extraction portion 5a) of the adjacent solar cell elements 10 are connected with an inner lead 11.

The inner lead 11 connected to the first electrode 4 has a liner shape in which one side is longer than the other side in a plain view. A direction shown with an arrow M in FIGS. 2 and 3 indicates a longitudinal direction of the inner lead. A direction shown with an arrow N indicates a lateral direction of the inner lead.

Next, a manufacturing process of the solar cell element 10 having the above structure will be described.

When the substrate 1 is a monocrystalline silicon substrate 1, it is formed by, e.g., a pulling method, and when the substrate 1 is a polycrystalline silicon substrate 1, it is formed by, e.g., a casting method. Mass production is possible for the polycrystalline silicon substrate 1, which is more advantageous than the monocrystalline silicon substrate 1 in view of manufacturing cost, and therefore, an example using polycrystalline silicon will be described here.

In order to prepare the substrate 1, first, an ingot of polycrystalline silicon is prepared by, e.g., the casting method. For instance, a p-type polycrystalline silicon ingot is formed by melting and solidifying silicon material including a dopant of B or the like. The ingot of polycrystalline silicon is sliced to have the thickness of, e.g. 350 µm or less, or more preferably, 200 µm or less, and cut into the size of approximately 10 cm by 10 cm to 25 cm by 25 cm to prepare the substrate 1. In order to clean a part being damaged and a part being contaminated in a cross-sectional surface of the substrate 1, etching is preferably performed in only a trace amount on the surface with NaOH, KOH, hydrofluoric acid or fluoro-nitric acid. Thereafter, it is more preferable to form microscopic projections on the surface of the substrate 1, using a dry etching method or a wet etching method.

Next, the n-type diffusion layer 2 is formed in the substrate 1. This forms a pn junction between the p-type bulk region and the diffusion layer 2. This diffusion layer 2 is formed by an application and thermal-diffusion method in which P₂O₅ in paste form is applied to the surface of the substrate 1 and then thermally diffused, a vapor-phase thermal-diffusion method in which POCl₃ (phosphorus oxychloride) in gas form is used as a diffusion source, and an ion implantation method in which phosphorus ions are directly diffused. This diffusion layer 2 is formed to have the depth of approximately 0.2 to 0.5 µm. Note that the formation method of the diffusion layer 2 is not limited to the above methods, but a crystalline silicon film including an amorphous silicon hydride film, a microcrystalline silicon film, or the like may be formed using a thin-film deposition technique, for example. Further, an i-type silicon region may be formed between the substrate 1 and the diffusion layer 2.

Next, the antireflective film 3 is formed. The antireflective film 3 is formed using a plasma enhanced chemical vapor deposition (PECVD) method, a vapor deposition method, a sputtering method or the like.

Next, the BSF region 6 in which a semiconductor impurity of a first conductivity type is diffused in high concentration is formed at the second surface side of the substrate 1. As a p-type impurity element, such as B and Al are used, and an ohmic contact is achieved between impurity and the second electrode 5 described later by having p⁺ type with an impurity element of high concentration. As a method, such as a method of forming at a temperature of approximately 800 to 1100°C by a thermal diffusion method using BBr₃ (boron tribromide) as a diffusion source, and a method in which an Al paste that includes an Al powder, an organic vehicle, and the like is applied by a printing method and then the applied paste is subjected to heat treatment (firing) at a temperature of approximately 600 to 850°C so that Al is diffused to the substrate 1, are used.

When this BSF region 6 is formed by the thermal diffusion method, preferably, a diffusion barrier of oxide film or the like is previously formed on the already-formed diffusion layer 2. If a method of printing and firing the Al paste is used, in addition that a predetermined diffusion region can be formed only on the printed surface, it is unnecessary to remove the n-type diffusion layer 2 formed at the side of the second surface simultaneously as the formation of the diffusion layer 2, and PN isolation may be performed on only the periphery at the second side surface using a laser and the like.

Note that the formation method of the BSF region 6 is not limited to the above methods, but a crystalline silicon film including an amorphous silicon hydride film, a microcrystalline silicon film, or the like may be formed using a thin-film deposition technique. Further, an i-type silicon region may be formed between the substrate 1 and the BSF region 6.

Next, the first electrode 4 (first output extraction portion 4a, first power collection unit 4b), and the second electrode 5 (second output extraction portion 5a, second power collection unit 5b) are formed as described below.

The first electrode 4 is formed, using an Ag paste obtained in paste form by adding a metal powder composed of, e.g. silver (Ag), and 10 to 30 parts by weight of an organic vehicle as well as 0.1 to 10 parts by weight of a glass frit per 100 parts by weight of Ag, for example. The Ag paste is applied on the first surface of the substrate 1, and then the first electrode 4 is formed by being fired at a maximum temperature of 600 to 850°C for approximately several tens of seconds to several tens of minutes. A screen printing method or the like may be used as a method of application, and preferably, after the application of the paste, a solvent is evaporated at a predetermined temperature so as to dry the paste.

Next, the second electrode 5 will be described. First, the second power collection unit 5b is formed, using an Al paste including, e.g. an Al powder and 10 to 30 parts by weight of an organic vehicle per 100 parts by weight of Al. This paste is applied to almost the entire surface of the second surface of the substrate 1 except a portion in which the second output extraction portion 5a is formed. A screen printing method or the like is used as a method of application. Preferably, after the application of the paste, a solvent is evaporated at a predetermined temperature so as to dry the paste.

Next, the second output extraction portion 5a is formed, using the Ag paste obtained in paste form by adding a metal powder composed of the Ag powder and 10 to 30 parts by weight of the organic vehicle as well as 0.1 to 5 parts by weight of the glass frit per 100 parts by weight of Ag, for example. This Ag paste is applied in a previously determined form. Note that the second output extraction portion 5a and a part of the second power collection unit 5b are overlapped by applying the Ag paste on a location contacting with a part of the Al paste. A screen printing method or the like may be used as a method of application, and preferably, after the application, a solvent is evaporated at a predetermined temperature so as to dry the paste.

Then, by firing the substrate 1 in a firing furnace at a maximum temperature of 600 to 850°C for approximately several tens of seconds to several tens of minutes, the second electrode 5 is formed on the substrate 1.

A printing method or firing method is used for forming electrodes in the above, but it is also possible to form electrodes using a plating, or a thin film formation such as vapor deposition or sputtering.

As described above, the solar cell element according to the present embodiment is manufactured.

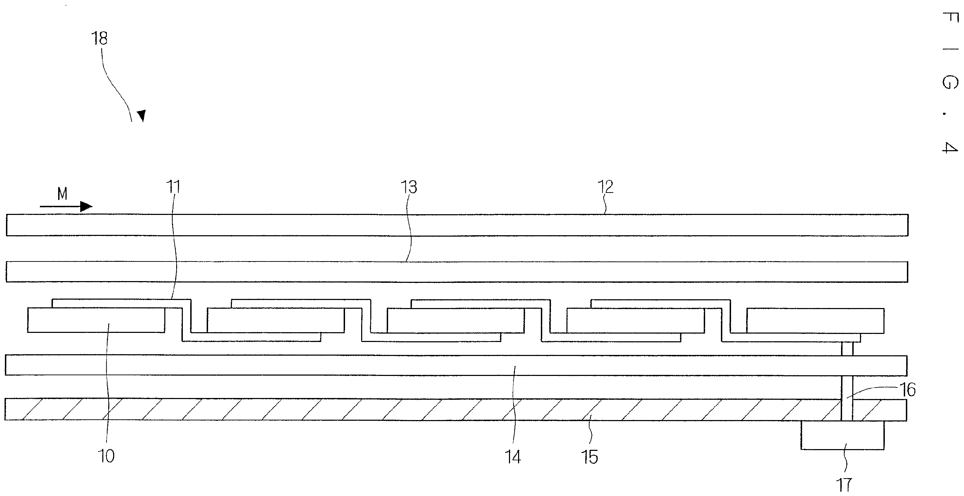

FIG. 4 is a sectional view of a solar cell module 18 according to the present embodiment. As shown in FIG. 4, the solar cell module 18 includes a translucent member 12 made of glass or the like, a first filler 13 made of translucent ethylene-vinyl acetate copolymer (EVA) or the like, a plurality of solar cell elements 10 connected to each other with the inner lead 11 of metal foil or the like, a second filler 14 made of translucent or white EVA, and a protection member 15 in which polyethylene telephthalate (PET) or metal foil is sandwiched with polyvinyl fluoride resin (PVF). Among the plurality of solar cell elements 10, ends of electrodes in the first and the last of the solar cell elements are connected to a terminal box 17 as is an output extraction portion, with an outer lead 16.

A copper foil having a thickness of approximately 0.1 to 0.2 mm and a width of approximately 1 to 2 mm, the entire surface of which is covered by soldering is used for the inner lead 11 connecting these plurality of solar cell elements 10, and is soldered onto the first electrode 4 (first output extraction portion 4a) and the second electrode 5 (second output extraction portion 5a) of the solar cell element 10. In FIG. 4, one end of the inner lead 11 is connected to the first output extraction portion 4a and the other end is connected to the second output extraction portion 5a of the adjacent solar cell element 10, thereby the inner lead 11 connects the adjacent two solar cell elements. In FIG. 4, one end of the inner lead 11 is connected along with the longitudinal direction of the first output extraction portion 4a. The other end of the inner lead 11 is connected along the longitudinal direction of the second output extraction portion 5a.

Each of the above-described members is sequentially stacked, deaerated, heated and pressed in a laminator to harden the first and second fillers 13, 14 and each member is integrated, thereby obtaining the solar cell module 18. Thereafter, if desired, a frame made of such as Al may be fitted to the periphery.

Next, the structure of the first electrode 4 and the second electrode 5 of the solar cell module according to the present embodiment will be described referring to Figures.

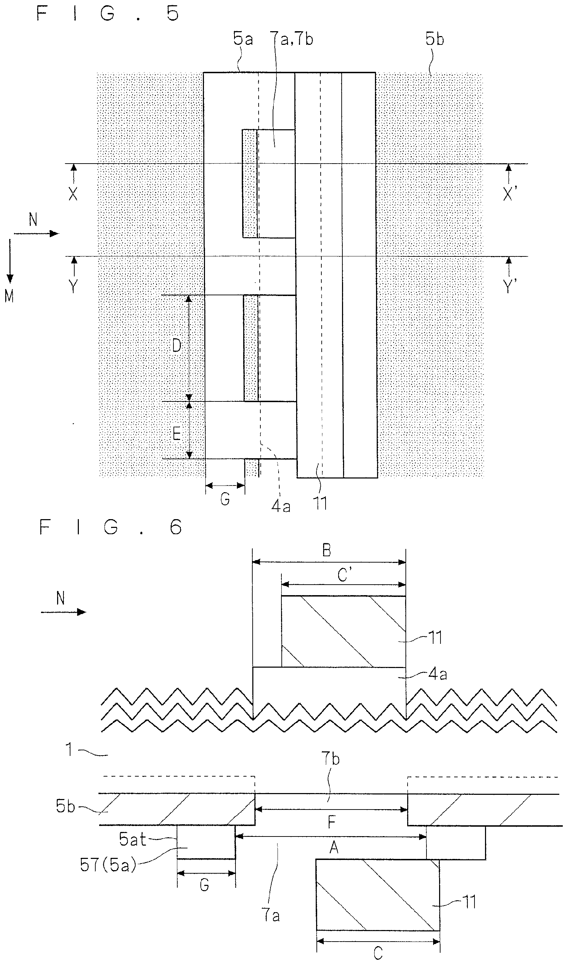

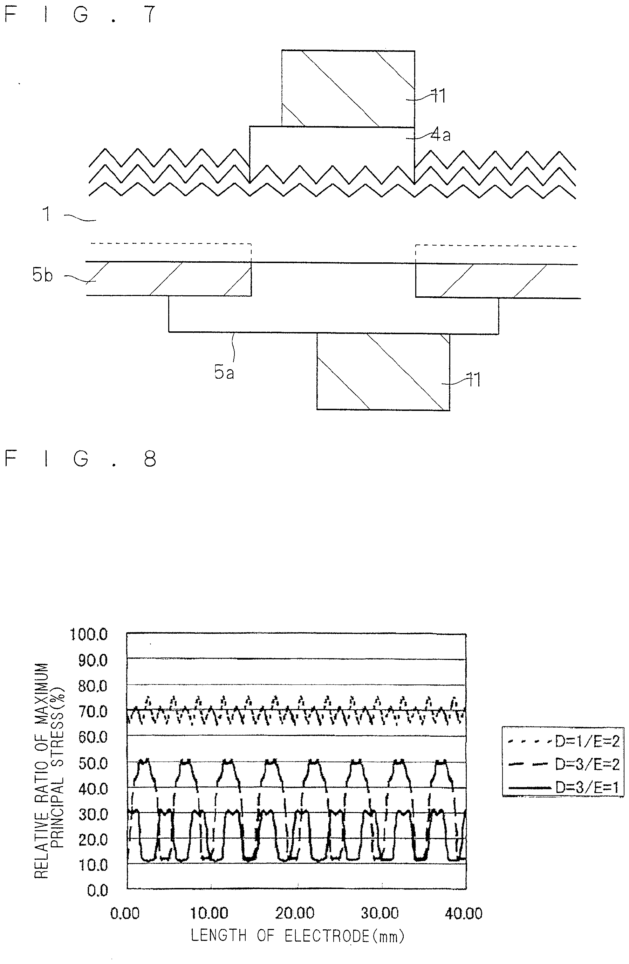

FIG. 5 is an enlarged view of the second electrode 5, FIG. 6 is a sectional view, taken along a line X-X' of FIG. 5, and FIG. 7 is a sectional view, taken along a line Y-Y' of FIG. 5. The solar cell element used for the solar cell module in the present embodiment includes the first electrode 4 including the first output extraction portion 4a on the first surface of the substrate 1, and the second electrode 5 including the second output extraction portion 5a immediately below near the vicinity of the periphery of the first electrode 4 in the second surface.

The second electrode 5 overlaps on the first electrode 4 in a perspective plane view, and a part of the periphery of the first electrode 4 is disposed in the first opening 7a in a perspective plane view. In FIG. 5, a width A of the first opening 7a in the lateral direction of the second output extraction portion 5a is greater than a width B of the first output extraction portion 4a. This structure reduces the stress generated in the substrate 1 located near the first electrode 4, caused by heat contraction of tabbing and the like of the inner lead 11 in the second electrode 5 and the back surface. Accordingly, peeling of a surface part of the substrate 1 is reduced, thereby improving the reliability of the solar cell module.

As shown in FIG. 6, even if the inner leads 11 on the front surface and on the back surface is located not at a central part of an electrode but at an end of the electrode, a very thin surface part of the substrate 1 is less likely to be peeled off, and thus the problems such as generating a large crack or damaging the appearance can be reduced.

When the width A of the first opening 7a is greater than a width C of the inner lead 11, the second output extraction portion 5a is connected to only one end of the inner lead 11. Therefore, contraction stress by which the substrate near the first electrode 4 is convexly lifted is not likely to be generated. Also, the stress is dispersed by providing a plurality of first openings 7a, and thus the generation of cracks can be reduced. The width A of the first opening 7a is designed to be, e.g. 2 mm or more and 3 mm or less, and the width B of the first output extraction portion 4a is, e.g. 1.3 mm or more and 2.5 mm or less.

As shown in FIG. 5, a plurality of first openings 7a are provided along the longitudinal direction of the second output extraction portion 5a with intervals. In FIG. 5, a length D of the first opening 7a in the longitudinal direction of the inner lead 11 is greater than an interval E between the plurality of first openings 7a.

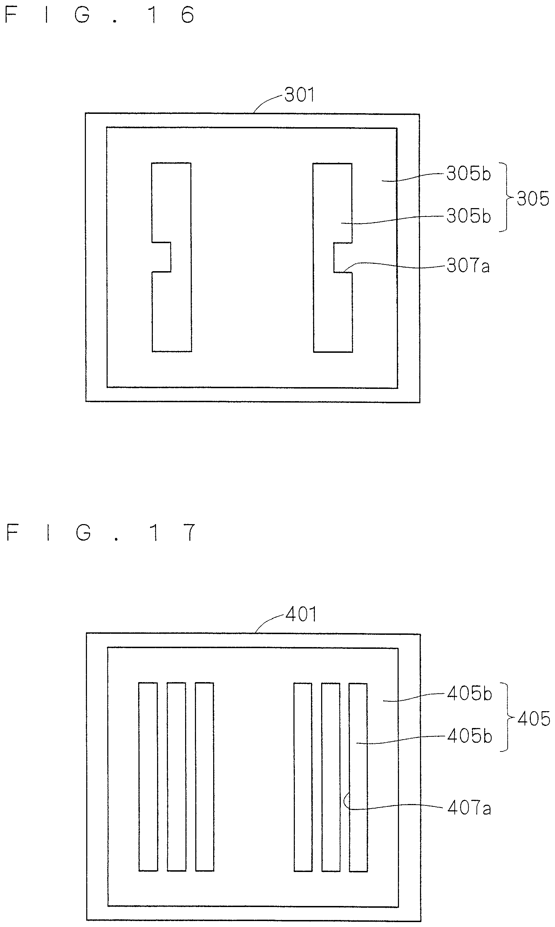

These first openings 7a may be overlapped with at least a part of the entire periphery of the first electrode 4 in a perspective plane view. For instance, the first opening 7a may be formed to be surrounded on all four sides by the second electrode 5, and may be formed to be surrounded on two sides or three sides (e.g. a slit-like opening, a concave opening in a plain view, or the like). A concave opening and a slit-like opening are shown in FIGS. 16 and 17. In FIG. 16, a substrate 301 corresponds to the substrate 1, a second output extraction portion 305a corresponds to the second output extraction portion 5a, a second power collection unit 305b corresponds to the second power collection unit 5b, a second electrode 305 corresponds to the second electrode 5, and a first opening 307a corresponds to the first opening 7a, respectively. In FIG. 17, a substrate 401 corresponds to the substrate 1, a second output extraction portion 405a corresponds to the second output extraction portion 5a, a second power collection unit 405b corresponds to the second power collection unit 5b, a second electrode 405 to the second electrode 5, and a first opening 407a corresponds to the first opening 7a, respectively. Especially when the first opening 7a is formed to be surrounded on all four sides by the second electrode 5, resistance loss of the second electrode 5 can be suppressed.

The first opening 7a may be formed only in the second output extraction portion 5a in the second electrode 5. Even in this case, the stress in the periphery of the first electrode 4 on the first surface of the substrate 1 is reduced in a region where this first opening 7a is formed.

Here, that the first output extraction portion 4a and the second output extraction portion 5a are "linear" indicates the case where the first output extraction portion 4a and the second output extraction portion 5a are formed to be linear with respect to the surface of the substrate 1 as a whole, including the case where they are arranged to be continuously linear without space, as well as the case where a plurality of components are arranged to be linear with space.

In FIG. 6, a width C' of the inner lead 11 connected to the first output extraction portion 4a is smaller than the width B of the first output extraction portion 4a. Such a configuration can reduce the decrease of an area receiving a light in the solar cell element 10 due to the shade of the inner lead 11. Further, even if the inner lead 11 is greatly misaligned, the inner lead 11 is less likely to connect to an end of the first output extraction portion 4a, thereby reducing the stress applied near the first electrode 4. The width C of the inner lead 11 is designed to be, e.g. 1 mm or more and 2 mm or less.

FIG. 8 shows the simulation result of the change in major principal stress when a length D of the first opening 7a and the intervals E between the plurality of first openings are changed. The horizontal axis indicates the location of an electrode in the longitudinal direction of the second output extraction portion 5a, and the vertical axis indicates the relative ratio of the major principal stress in each condition when the major principal stress of the electrode configuration in which an opening is not provided is set to be 100%. Since the stress applied to the substrate 1 near the first output extraction portion 4a is further dispersed by setting the length D of the first opening 7a to be larger and setting the intervals E of the plurality of first openings to be smaller, the major principal stress is found to be reduced. The length D of the first opening 7a is designed to be 2 mm or more and 5 mm or less, the interval E between the plurality of first openings is designed to be 1 mm or more and 3 mm or less. Here, the major principal stress is a maximum value of the normal stress when the coordinate system is obtained so that a shearing stress component is zero.

The second power collection unit 5b includes a second opening 7b in a part where the second output extraction portion 5a is located. At this time, a width F of the second opening 7b in a lateral direction N of the inner lead 11 is preferably greater than the width B of the first output extraction portion 4a. Since the solar cell element 10 does not include the first electrode 4 and the second power collection unit 5b immediately below the vicinity thereof, the stress applied to the first electrode 4 and the substrate 1 located in the vicinity thereof due to the heat contraction is reduced, and at the same time, the contact area of the second output extraction portion 5a and the substrate 1 is increased, so that the electrode intensity of the second output extraction portion 5a and the substrate 1 is maintained. The width F of the second opening is designed to be 1.5 mm or more and 2.8 mm or less. The electrode intensity refers to a load value when the electrode joined to an object is peeled off from the object by adding tension load.

Further, the width A of the first opening 7a in the lateral direction N of the inner lead 11 is preferably greater than the width F of the second opening 7b. That is, the relation of A > F > B is preferably established. Thereby, a part where the second output extraction portion 5a overlaps superimposes on the second power collection unit 5b is located apart from the first electrode 4 to which the inner lead 11 is connected, and thus the stress applied to the substrate 1 due to the heat contraction can be further reduced. When the Al paste is printed and fired so as to form the second power collection unit 5b, the BSF region 6 can be simultaneously formed to be large so that the characteristics of the solar cell element is improved.

A side surface 5at of the output extraction portion 5a and a width G of the first opening 7a are preferably smaller than the width A of the plurality of first openings 7a. The width A and the width G are widths in the lateral direction of the second output extraction portion 5a. Such a configuration reduces resistance of the second output extraction portion 5a and allows carriers collected by the second power collection unit 5b to be efficiently extracted to the second output extraction portion 5a, and thus resistance loss can be suppressed. The width G of one end of the electrode is smaller than the interval E between the plurality of first openings 7a so that the stress applied to the substrate 1 in the part where the second output extraction portion 5a overlaps with the second power collection unit 5b is reduced. The width G of one end of the electrode is designed to be, e.g. 0.75 mm or more and 2 mm or less. Here, the side surface 5at of the output extraction portion 5a of the second electrode refers to an end surface 5at along the longitudinal direction of the second output extraction portion 5a in a plane view.

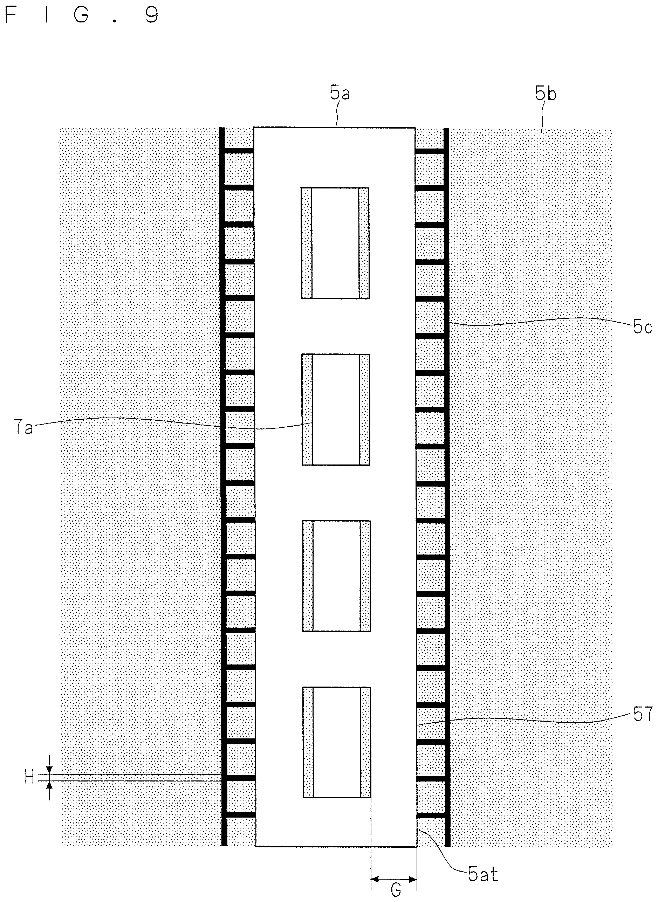

As shown in FIG. 9, a third output extraction portion 5c made of a thin line having a width H smaller than the width G between the side surface 5at of the second output extraction portion 5a and the first opening 7a is preferably connected to the second output extraction portion 5a. That is, the second electrode 5 preferably includes the output extraction portion 5a and the third output extraction portion 5c. Thereby, the carriers collected by the second power collection unit 5b are extracted from the third output extraction portion 5c to the second power collection unit 5b, and thus the resistance los can be suppressed, so that the resistance loss of the second electrode 5 as a whole is suppressed to prevent deterioration of electrical characteristics. The third output extraction portion 5c is composed of a thin line having a line width H of, e.g. 0.05 mm or more and 0.5 mm or less. With such a range, contraction stress of a metal composing the third output extraction portion 5c is dispersed, thereby reducing the stress applied to the second power collection unit 5b.

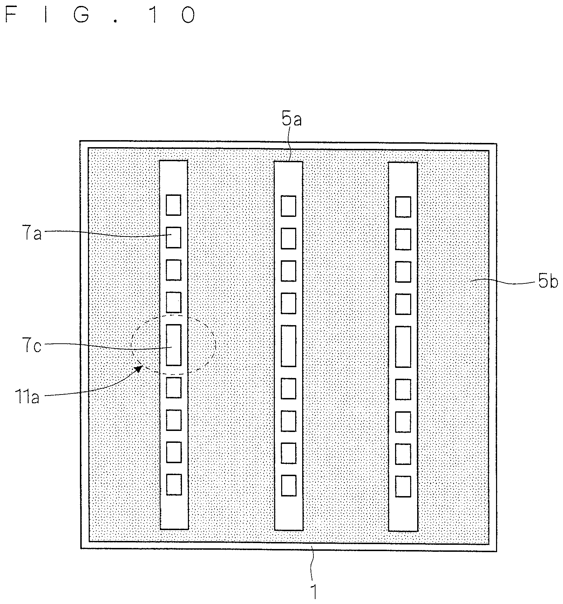

In FIG. 10, the second output extraction portion 5a of the second electrode includes a third opening 7c in a central region 11a in the longitudinal direction of the inner lead 11, and the second power collection unit 5b is exposed in the third opening 7c. Such a configuration increases power collection efficiency in the second power collection unit 5b and suppresses the resistance loss of the second electrode 5 as a whole, so that the electrical characteristics is unlikely to be deteriorated. Such a solar cell element 10 is easily used for a cut cell formed by dividing the solar cell element 10 in a central part. As shown in FIG. 10, a length of the third opening 7c in the longitudinal direction of the second output extraction portion 5a is greater than the length of other first openings 7a.

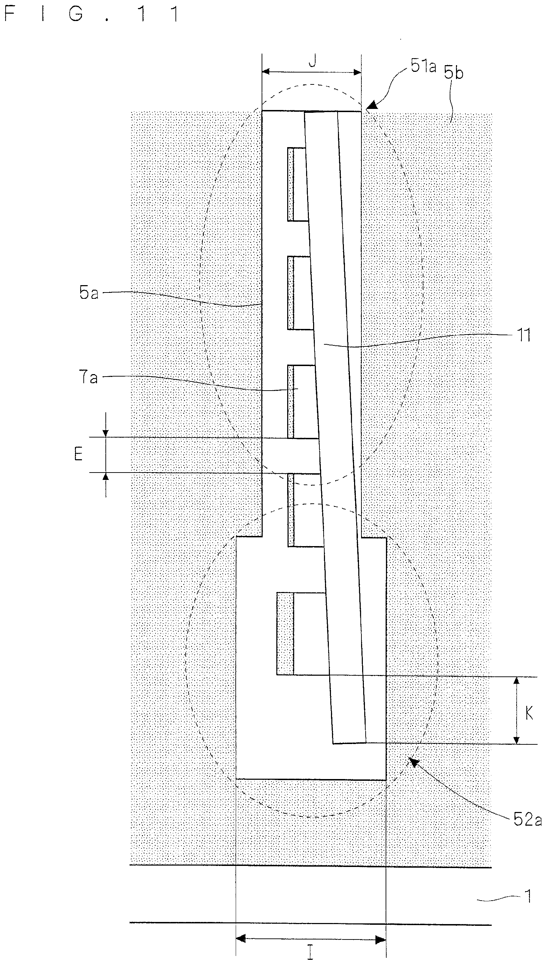

As shown in FIG. 11, the second output extraction portion 5a includes a first part 51a located in the central region of the substrate 1 and having a width J in the lateral direction of the inner lead 11, and a second part 52a located in the peripheral region of the substrate 1 and having a width I greater than the first part 51a. Therefore, even at the end part of the substrate 1, the inner lead 11 is easily disposed on the second output extraction portion 5a. The width I is designed to be greater than the width J by, e.g. 1 mm or more and 3 mm or less. The first part 51a may be located closer to the central part of the substrate 1, and the second part 52a may be located closer to the periphery of the substrate 1 than the first part 51a, for example, the second part 52a does not have to be located at a place in contact with the periphery of the substrate 1. The width of the first opening 7a in a region where the width of the second output extraction portion 5a at the end part of the substrate 1 is increased may be increased more than the width of the first opening 7a located in the central part. Further, a length K of a bonding region of the second output extraction portion 5a and the inner lead 11 at the end part of the substrate is preferably greater than the interval E between the plurality of first openings 7a. In this case, the bonding strength between the second output extraction portion 5a and the inner lead 11 at the end of the inner lead 11 is increased, and peeling of the end of the inner lead 11 is reduced thereby, making peeling of the end difficult to progress and preventing the entire inner lead 11 from peeling off from the output extraction portion 5a. The length K of the bonding region is designed to be 2 mm or more and 5 mm or less.

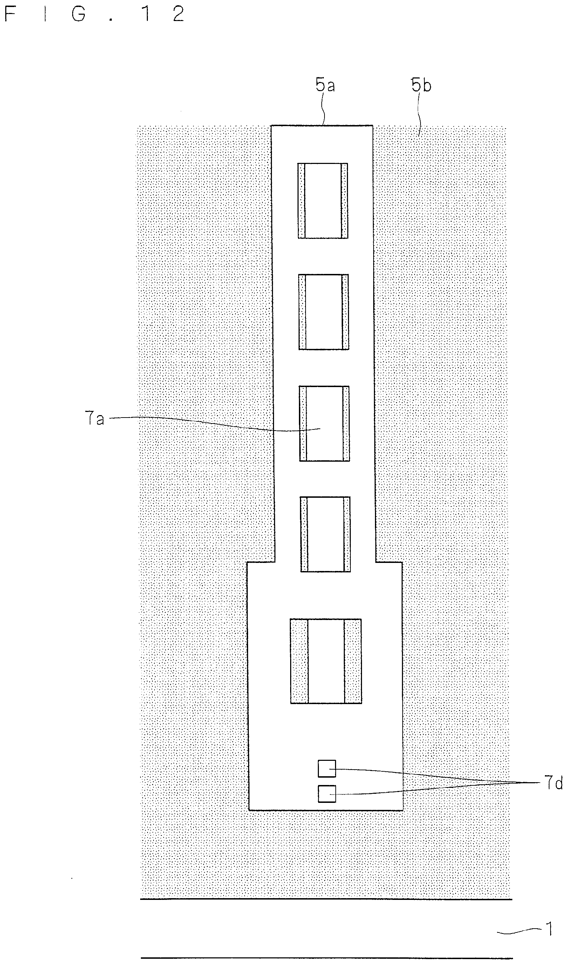

As shown in FIG. 12, the second output extraction portion 5a preferably includes a fourth opening 7d smaller than the first opening 7a at the periphery of the substrate 1, and according to the present embodiment, the two continuous fourth openings 7d are included at the end part of the substrate of the second output extraction portion 5a. A thickness of an electrode between the two fourth openings 7d is measured by scanning from the one fourth opening 7d to the other fourth opening 7d with a contact type or non-contact type thickness measurement equipment, allowing thickness management of the end part of the substrate of the second output extraction portion 5a. When the electrode is formed by a screen-printing, the thickness of the electrode varies at the end part of the substrate, comparing to the central part of the second output extraction portion 5a. Therefore, the thickness is measured immediately after printing or firing, so that the process can be instantly adjusted if the thickness of the end part of the substrate of the electrode is beyond a stipulated range. The size of the fourth openings 7d may be approximately 0.5 to 1.5 mm, and interval therebetween may be approximately 0.5 to 3 mm.

The inner lead 11 is connected to the first output extraction portion 4a or the second output extraction portion 5a with a solder, and a lead-free solder not including lead is preferred and good for environment. The problems such as chipping on very thin surface part of the substrate 1, are reduced by having the configuration of the present embodiment of the invention even when the lead-free solder is used. The lead-free solder for use may be Sn-Ag base, Sn-Ag-Cu base, Sn-Bi base, Sn-Bi-Ag base, Sn-Cu-Bi base, Sn-Cu base, Sn-Zn-Bi base, or Sn-Sb base.

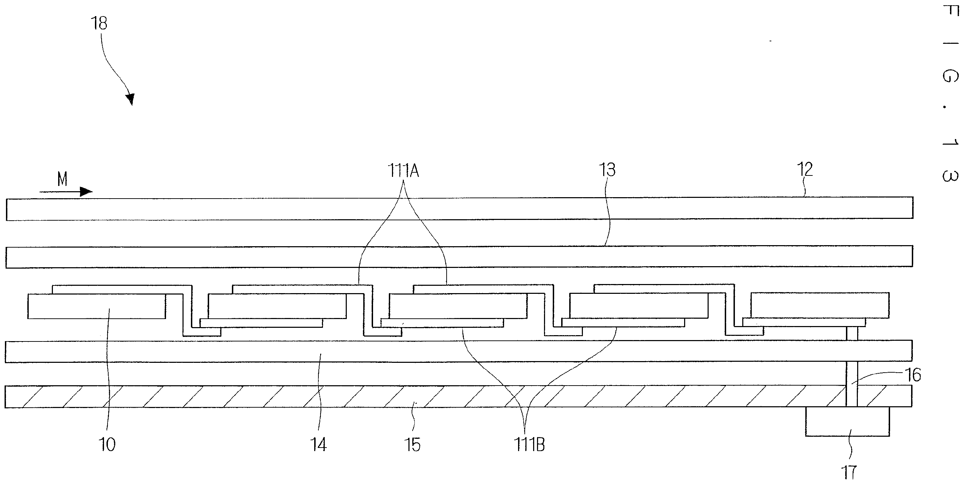

In the above preferred embodiment, the example of connecting the first output extraction portion 4a of the substrate 1 and the adjacent second output extraction portion 5a of the substrate 1 with a single inner lead 11 has been described, but it does not have to be the same necessarily. For instance, as shown in FIG. 13, a first inner lead 11A is connected to the first output extraction portion 4a of the substrate 1 along the longitudinal direction thereof, and a second inner lead 11B is connected to the second output extraction portion 5a of the substrate 1 along the longitudinal direction thereof. An outwardly extending end of the first inner lead 11A and an outwardly extending end of the second inner lead 11B may be configured to be connected to each other by soldering and the like between the adjacent substrate 1.

Even in this case, thermal influence when each of the inner leads 11A, 11B is connected by soldering or the like is reduced in the region of the first opening 7a, and thus the same effect as above can be obtained.

### <Second Embodiment>

A solar cell module according to a second embodiment will be described.

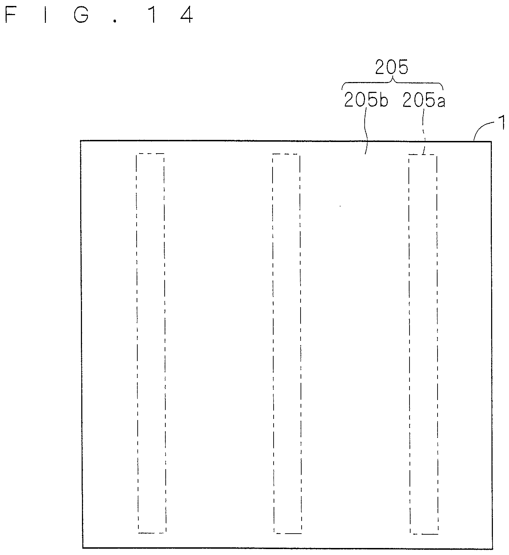

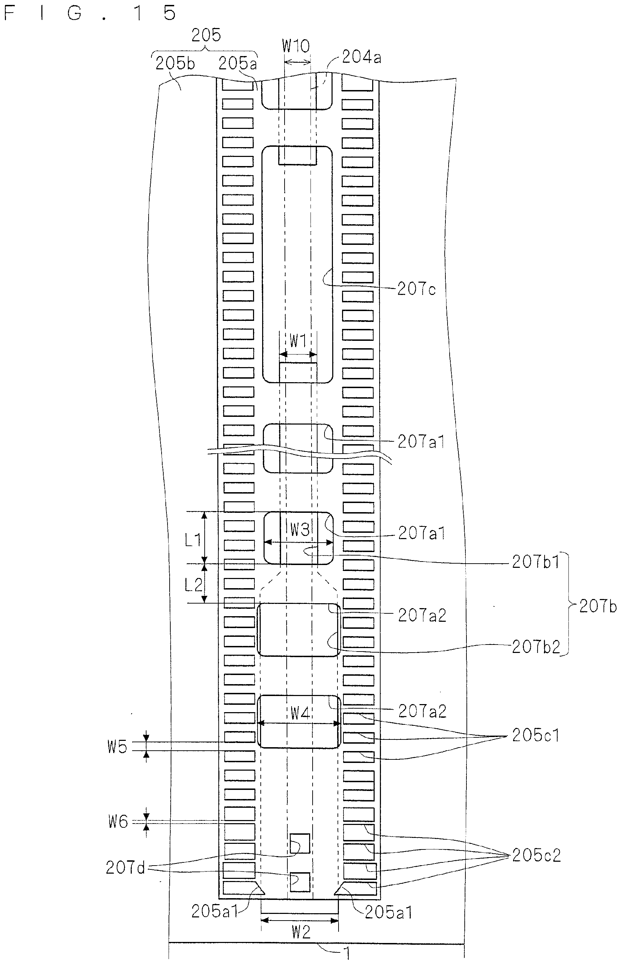

FIG. 14 is a schematic view showing a part of a second surface side (back surface) of the solar cell module according to the second embodiment, and FIG. 15 is a partially enlarged view of FIG. 14. FIG. 15 illustrates a substantially half part in the longitudinal direction of one of a plurality of second output extraction portions 205a shown in FIG. 14.

The second embodiment is described, focusing on the differences with the above first embodiment.

This solar cell module includes a second electrode 205 corresponding to the above second electrode 5 on the second surface of the substrate 1.

The second electrode 205 includes a second output extraction portion 205a corresponding to the above second output extraction portion 5a and a second power collection unit 205b corresponding to the above second power collection unit 5b.

The second power collection unit 205b is formed to spread on a surface so as to cover the substantially entire back surface of the substrate 1, and the second output extraction portion 205a is formed to extend to be linear.

In a part of the second power collection unit 205b where the second output extraction portion 205a is formed, a second opening 207b is formed to be substantially linear. However, a width of the second output extraction portion 205a is greater than that of the second opening 207b. Accordingly, the second output extraction portion 205a makes contact with the substrate 1 in the second opening 217b, and makes contact with the second power collection unit 205b at both sides of the second opening 207b.

The second opening 207b is divided in the central part of the substrate 1 in the longitudinal direction, and the second power collection unit 205b is formed therein. This part of the second power collection unit 205b is exposed to the back surface of the substrate 1 through a third opening 207c described later.

A width W2 of a part 207b2 of the second opening 207b closer to the periphery of the substrate 1 is formed to be greater than a width W1 of a part 207b1 of the second opening 207b closer to the substantially center of the substrate 1. Thereby, generation of cracks is reduced in the end part of the second output extraction portion 205a. That is, the vicinity of the end part of the second output extraction portion 205a is opened to outside (in other words, in a region of the central part of the inner lead, the force of heat contraction of the inner lead is applied to the both sides of the region, so that contraction force is easily applied to the inner lead uniformly, but in a region near the end of the inner lead, heat contraction of the inner lead is applied to only one side of the region), so that ununiformity of heat contraction degree is easily caused to generate cracks, when soldering and the like is performed on the second output extraction portion 205a. Therefore, an overlapping region of the second output extraction portion 205a and the second power collection unit 205b is made smaller near the end part of the second output extraction portion 205a by widening the part 207b2 of the second opening 207b of the second power collection unit 205b, so that influence of heat stress of the second output extraction portion 205a and the second power collection unit 205b is difficult to affect on the substrate 1, thereby further reducing the generation of cracks.

Of course, the widths W1 and W2 of the parts 207b1 and 207b2 of the second opening 207b are greater than a width W10 of the first output extraction portion 204a which is a first electrode of the front side of the substrate 1. Thereby, the second power collection unit 205b is not disposed immediately below both edge parts of the first output extraction portion 204a in a perspective plane view, further reducing the influence of heat contraction caused by the second power collection unit 205b. Further, in a part without the first openings 207a1 and 207a2, the contact area of the second output extraction portion 205a and the substrate 1 is made larger, thereby maintaining the electrode intensity of the second output extraction portion 205a.

The second output extraction portion 205a is formed to be substantially linear such that a width of the lateral direction is substantially the same in the substantially entire longitudinal direction. The second output extraction portion 205a includes the first openings 207a1 and 207a2 corresponding to the above first opening 7a. A plurality of first openings 207a1 and 207a2 are provided along the longitudinal direction of the second output extraction portion 205a with intervals. Each of the first openings 207a1 and 207a2 has widths W3 and W4 greater than the width W10 of the first output extraction portion 204a similarly to the above first opening 7a. Accordingly, the generation of cracks due to the heat stress of the second electrode 205 is reduced.

In each part of the longitudinal direction of the second output extraction portion 205a, the widths W3 and W4 of the first openings 207a1 and 207a2 are greater than the widths W1 and W2 of the second opening 207b. Here, in the substantially middle part of the longitudinal direction of the second output extraction portion 205a, the width W3 of the first opening 207a1 is greater than the width W1 of a middle part 207b1 of the longitudinal direction of the second opening 207b, and in the end part of the second output extraction portion 205a, the width W4 of the first opening 207a2 is greater than the width W2 of the end part 207b2 of the longitudinal direction of the second opening 207b. That is, the relation of W3 or W4 (width of the first opening) > W1 or W2 (width of the second opening) > W10 (width of the first output extraction portion 204a) is preferably established. Thereby, the overlapping part of the second power collection unit 205b and the second output extraction portion 205a is provided outside the both edge parts of the first output extraction portion 204a, so that the influence of heat contraction of the second power collection unit 205b and the second output extraction portion 205a hardly acts on the vicinity of the first output extraction portion 204a. Further, even the connection part of the second output extraction portion 205a and the inner lead is provided outside the both edge parts of the first output extraction portion 204a, so that thermal influence of the connection work hardly acts on the vicinity of the first output extraction portion 204a. As a result, the generation of cracks in the substrate 1, particularly, the generation of cracks in the vicinity of the first output extraction portion 204a is further reduced.

Similarly to the above first embodiment, in the longitudinal direction of the second output extraction portion 205a, a length L1 of the above first openings 207a1 and 207a2 is set to be longer than a length L2 between the first openings 207a1 and 207a2. Thereby, the stress caused by the second power collection unit 205b and affected on the substrate 1 is dispersed, and the generation of cracks in the substrate 1 is further efficiently reduced.

In the longitudinal direction of the second output extraction portion 205a, a width W4 of at least one (here two) of the first openings 207a2 closer to the periphery of the substrate 1 is greater than a width W3 of at least one (here many) of the first openings 207a1 closer to the center of the substrate 1. Thereby, the possibility of connecting the inner lead to the second output extraction portion 205a at both sides of the first opening 207a2 is reduced, thereby reducing the influence of thermal stress acting on the substrate 1. That is, from the viewpoint of preventing the influence of thermal stress from affecting on the substrate 1 when the inner lead is soldered to the second output extraction portion 205a, the inner lead is preferably not connected to the second output extraction portion 205a in the first openings 207a1 and 207a2. However, in terms of the accuracy of inner lead arrangement and the like, in the end part of the second output extraction portion 205a, misalignment of the inner lead in the lateral direction of the second output extraction portion 205a tends to be greater. Then, by forming the first opening 207a2 to be wider, the inner lead is placed in the first opening 207a2 even when the inner lead is misaligned as above. That is, the possibility of connecting the inner lead to the second output extraction portion 205a at both sides of the first opening 207a2 is reduced. Thereby, the influence of thermal stress acting on the substrate 1 is reduced.

If the inner lead is connected to the second output extraction portion 205a at both sides of the first opening 207a2, it is possible to produce a state where only one side thereof is connected. Thereby, the influence of thermal stress on the substrate 1 is reduced, comparing to the case of connecting the inner lead to the second output extraction portion 205a at both sides of the first opening 207a2.

The middle part of the longitudinal direction of the second output extraction portion 205a includes a third opening 207c exposing the second power collection unit 205b, similarly to the above third opening 7c. Thereby, similarly to the description referring to FIG. 10, deterioration of electrical characteristics is reduced, increasing the power collection efficiency as well as suppressing the resistance loss of the entire second electrode 205.

The end part near the periphery of the substrate 1 in the second output extraction portion 205a is formed in an inclination side 205a1 inwardly inclining toward the end part. Thereby, peeling at the end part of the second output extraction portion 205a is to be reduced.

The second output extraction portion 205a includes a fourth opening 207d smaller than the first openings 207a1 and 207a2 in the periphery of the substrate 1, here, closer to the periphery of the substrate 1 than the first openings 207a1 and 207a2. The fourth opening 207d is served for the thickness management and the like at the end part of the substrate of the second output extraction portion 205a, similarly to the fourth opening 7d described referring to FIG. 12.

At the both sides of the second output extraction portion 205a, third output extraction portions 205c1 and 205c2 corresponding to the third output extraction portion 5c in the first preferred embodiment are connected. The third output extraction portions 205c1 and 205c2 have a width smaller than a portion sandwiched between a side surface of the second output extraction portion 205a and the first opening 207a1, similarly to the third output extraction portion 5c in the first preferred embodiment. The third output extraction portions 2051c and 205c2 may have, in at least one of the first openings 207a1, a width smaller than a portion sandwiched between that first opening 207a1 and the side surface of the second output extraction portion 205a, and it is not necessary to have the similar relation in all of the first openings 207a1 and 207a2. For instance, the third output extraction portion 2051c may have a width greater than a portion sandwiched between the first opening 207a2 at end part and the side surface of the second output extraction portion 205a.

In the plurality of third output extraction portions 205c1 and 205c2 provided to each of the both sides of the second output extraction portion 205a, a width W6 of the third output extraction portion 205c2 provided in the end part of the longitudinal direction of the second output extraction portion 205a (i.e. near the periphery of the substrate 1) is smaller than a width W5 of the third output extraction portion 205c1 provided in the middle part of the longitudinal direction of the second output extraction portion 205a (i.e. substantially middle part of the substrate 1). As a result, here, an opening shape between the third output extraction portions 205c2 is larger than an opening shape between the third output extraction portions 205c1, but these opening shapes may be substantially same.

The above configuration reduces the influence of the thermal stress in the end part of the second output extraction portion 205a, and also reduces the peeling of the third output extraction portion 205c2, the generation of cracks of the substrate 1, and the like. That is, since the vicinity of the end part of the second output extraction portion 205a is opened toward outside, when soldering and the like is performed on the second output extraction portion 205a, the ununiformity of heat contraction degree is easily caused. Therefore, by reducing the contact area of the third output extraction portion 205c2 and the second power collection unit 205b in the vicinity of the second output extraction portion 205a as much as possible, the thermal stress due to the third output extraction portion 205c2 hardly affects on the substrate 1, further reducing the peeling of the third output extraction portion 205c2 and the generation of cracks of the substrate 1.

### <Other Variations>

While the present invention is not limited to each of the above preferred embodiments, it is therefore understood that numerous modifications and variations can be devised without departing from the scope of the invention.

For instance, when the first electrode 4 and the second electrode 5 (second output extraction portion 5a, second power collection unit 5b) are formed by applying the Ag paste on the front surface and the A1 paste and the Ag paste on the back surface, firing may be performed either simultaneously or separately. The order of forming electrodes is not necessarily specified. Also, the example of forming the second output extraction portion 5a by forming the second power collection unit 5b and thereafter applying the Ag paste has been described, but the reverse may do.

Further, drying after applying a conductive paste may be omitted if there is not a problem that the previous conductive paste is adhered to a work table or screen of a printer when applying the next conductive paste.

The matters described in the above first embodiment, the matters described in the second embodiment, and the matters described in the variations can be appropriately combined unless opposing to one another.

## Claims

1. A solar cell module (10, 18), comprising:
a substrate (1) which comprises a first surface receiving a light and a second surface at a back side of the first surface;
a first electrode (4) provided on the first surface of the substrate (1); and
a second electrode (5) provided on the second surface of the substrate (1) and comprising an elongated second output extraction portion (5a),
wherein the second output extraction portion (5a) comprises a first opening (7a) below the first electrode (4),
wherein a part of a periphery of the first electrode (4) is disposed in an orthogonal projection of the first electrode on a plane parallel to the second surface in the first opening (7a), and wherein
the first electrode (4) comprises an elongated first output extraction portion (4a),
the solar cell module (10, 18) further comprising
a first inner lead (11) formed to be elongated and connected to the first output extraction portion (4a) along a longitudinal direction (M) of the first output extraction portion (4a), and
a second inner lead (11) formed to be elongated and connected to the second output extraction portion (5a) along a longitudinal direction (M) of the second output extraction portion (5a),
wherein the first opening (7a) has a width (A) greater than a width (B) of the first output extraction portion (4a) in a lateral direction (N) of the first output extraction portion (4a),
wherein the second electrode (5) comprises a power collection unit (5b) formed on the almost entire surface of the second surface of the substrate except in a portion defining a second opening (7b) at a back side of the first output extraction portion (4a),
wherein the second output extraction portion (5a) is formed on and overlapping a part of the second power collection unit (5b),
wherein the second opening (7b) is located in a part where the second output extraction portion (5a) is located, wherein
a width (F) of the second opening (7b) is greater than the width (B) of the first output extraction portion (4a), and
wherein a width (A) of the first opening is greater than a width (C) of the second inner lead.

2. The solar cell module according to claim 1,
wherein the first inner lead (11) had a width (C') smaller than a width (B) of the first output extraction portion (4a) in the lateral direction (N) of the first output extraction portion (4a).

3. The solar cell module according to claim 1, wherein
a plurality of the first openings (7a) are provided with intervals (E) along the longitudinal direction (M) of the second output extraction portion (5a), and
lengths (D) of the plurality of the first openings (7a) in the longitudinal direction (M) of the second output extraction portion (5a) are longer than the intervals (E) among the plurality of the first openings (7a).

4. The solar cell module according to claim 1,
wherein a length (G) between a side surface (5at) of the second output extraction portion (5a) and the first opening (7a) is smaller than a width (A) of the first opening (7a) in a lateral direction (N) of the second extraction portion (5a).

5. The solar cell module according to claim 1,
wherein the second electrode (5) comprises a third output extraction portion (5c) having a width (H) smaller than a length (G) between the side surface (5at) of the second output extraction portion (5a) and the first opening (7a), and connected to the second output extraction portion (5a).

6. The solar cell module according to claim 1,
wherein the second output extraction portion comprises a first part, and a second part located closer to a periphery of the substrate than the first part and having a width greater than that of the first part.

7. The solar cell module according to claim 1,
wherein the width (A) of the first opening (7a) is greater than the width (F) of the second opening (7b) in the lateral direction (N) of the first output extraction portion (4a).

8. The solar cell module according to claim 1,
wherein the second output extraction portion (205a) comprises a third opening, which has a width greater than that of the second opening, in a central region of the longitudinal direction thereof.

9. The solar cell module according to claim 1,
wherein the second output extraction portion comprises a fourth opening, which has a width smaller than that of the first opening, at a periphery side of the substrate.

10. The solar cell module according to claim 1,
wherein the first inner lead (11) is connected to the first output extraction portion (4a) or the second output extraction portion (5a) with lead-free solder.

11. The solar cell module according to claim 1, further comprising,
a crystalline silicon film between the first surface of the substrate (1) and the first electrode (4).

## Patentansprüche

1. Ein Solarzellenmodul (10, 18), aufweisend:
ein Substrat (1), das eine erste, ein Licht aufnehmende Fläche und eine zweite Fläche auf einer Rückseite der ersten Fläche aufweist,
eine erste Elektrode (4), die auf der ersten Fläche des Substrats (1) vorgesehen ist, und
eine zweite Elektrode (5), die auf der zweiten Fläche des Substrats (1) vorgesehen ist und einen langgestreckten zweiten Ausgangs-Extraktionsabschnitt (5a) aufweist,
wobei der zweite Ausgangs-Extraktionsabschnitt (5a) eine erste Öffnung (7a) unter der ersten Elektrode (4) aufweist,
wobei ein Teil eines Umfangs/Randbereichs der ersten Elektrode (4) in einer Orthogonalprojektion der ersten Elektrode auf einer Ebene parallel zu der zweiten Fläche in der ersten Öffnung (7a) angeordnet ist, und wobei
die erste Elektrode (4) einen langgestreckten ersten Ausgangs-Extraktionsabschnitt (4a) aufweist,
wobei das Solarzellenmodul (10, 18) ferner aufweist:
eine erste innere Leitung (11), die langgestreckt ausgebildet ist und entlang einer Längsrichtung (M) des ersten Ausgangs-Extraktionsabschnitts (4a) mit dem ersten Ausgangs-Extraktionsabschnitt (4a) verbunden ist, und
eine zweite innere Leitung (11), die langgestreckt ausgebildet ist und entlang einer Längsrichtung (M) des zweiten Ausgangs-Extraktionsabschnitts (5a) mit dem zweiten Ausgangs-Extraktionsabschnitt (5a) verbunden ist,
wobei die erste Öffnung (7a) eine Breite (A) hat, die in einer seitlichen Richtung (N) des ersten Ausgangs-Extraktionsabschnitts (4a) größer als eine Breite (B) des ersten Ausgangs-Extraktionsabschnitts (4a) ist,
wobei die zweite Elektrode (5) eine Strom-Sammeleinheit (5b) aufweist, die auf beinahe der gesamten Fläche der zweiten Fläche des Substrats ausgenommen in einem Abschnitt, der eine zweite Öffnung (7b) auf einer Rückseite des ersten Ausgangs-Extraktionsabschnitts (4a) definiert, ausgebildet ist,
wobei der zweite Ausgangs-Extraktionsabschnitt (5a) auf einem Teil der zweiten Strom-Sammeleinheit (5b) ausgebildet ist und diesen überlappt,
wobei die zweite Öffnung (7b) in einem Teil angeordnet ist, wob der zweite Ausgangs-Extraktionsabschnitt (5a) angeordnet ist, wobei
eine Breite (F) der zweiten Öffnung (7b) größer als die Breite (B) des ersten Ausgangs-Extraktionsabschnitts (4a) ist, und
wobei eine Breite (A) der ersten Öffnung größer als eine Breite (C) der zweiten inneren Leitung ist.

2. Das Solarzellenmodul gemäß Anspruch 1,
wobei die erste innere Leitung (11) eine Breite (C') hat, die kleiner als eine Breite (B) des ersten Ausgangs-Extraktionsabschnitts (4a) in der seitlichen Richtung (N) des ersten Ausgangs-Extraktionsabschnitts (4a) ist.

3. Das Solarzellenmodul gemäß Anspruch 1, wobei
eine Mehrzahl der ersten Öffnungen (7a) mit Abständen (E) entlang der Längsrichtung (M) des zweiten Ausgangs-Extraktionsabschnitts (5a) angeordnet ist, und
Längen (D) der Mehrzahl der ersten Öffnungen (7a) in der Längsrichtung (M) des zweiten Ausgangs-Extraktionsabschnitts (5a) länger als die Abstände (E) unter der Mehrzahl der ersten Öffnungen (7a) sind.

4. Das Solarzellenmodul gemäß Anspruch 1,
wobei eine Länge (G) zwischen einer Seitenfläche (5at) des zweiten Ausgangs-Extraktionsabschnitts (5a) und der ersten Öffnung (7a) kleiner als eine Breite (A) der ersten Öffnung (7a) in einer seitlichen Richtung (N) des zweiten Extraktionsabschnitts (5a) ist.

5. Das Solarzellenmodul gemäß Anspruch 1,
wobei die zweite Elektrode (5) einen dritten Ausgangs-Extraktionsabschnitt (5c) aufweist, der eine Breite (H) hat, die kleiner als eine Länge (G) zwischen der Seitenfläche (5at) des zweiten Ausgangs-Extraktionsabschnitts (5a) und der ersten Öffnung (7a) ist, und mit dem zweiten Ausgangs-Extraktionsabschnitt (5a) verbunden ist.

6. Das Solarzellenmodul gemäß Anspruch 1,
wobei der zweite Ausgangs-Extraktionsabschnitt einen ersten Teil und einen zweiten Teil aufweist, der näher bei einem Umfang des Substrats angeordnet ist als der erste Teil und der eine Breite hat, die größer als diejenige des ersten Teils ist.

7. Das Solarzellenmodul gemäß Anspruch 1,
wobei die Breite (A) der ersten Öffnung (7a) größer als die Breite (F) der zweiten Öffnung (7b) in der seitlichen Richtung (N) des ersten Ausgangs-Extraktionsabschnitts (4a) ist.

8. Das Solarzellenmodul gemäß Anspruch 1,
wobei der zweite Ausgangs-Extraktionsabschnitt (205a) eine dritte Öffnung in einem zentralen Bereich der Längsrichtung davon aufweist, die eine Breite hat, die größer als diejenige der zweiten Öffnung ist.

9. Das Solarzellenmodul gemäß Anspruch 1,
wobei der zweite Ausgangs-Extraktionsabschnitt eine vierte Öffnung auf einer Umfangsseite des Substrats aufweist, die eine Breite hat, die kleiner als diejenige der ersten Öffnung ist.

10. Das Solarzellenmodul gemäß Anspruch 1,
wobei die erste innere Leitung (11) mit bleifreiem Lot mit dem ersten Ausgangs-Extraktionsabschnitt (4a) oder dem zweiten Ausgangs-Extraktionsabschnitt (5a) verbunden ist.

11. Das Solarzellenmodul gemäß Anspruch 1, ferner aufweisend:
einen kristallines-Silicium-Film zwischen der ersten Fläche des Substrats (1) und der ersten Elektrode (4).

## Revendications

1. Un module de cellules solaires (10, 18), comportant :
un substrat (1) qui comprend une première surface recevant une lumière et une deuxième surface sur un côté arrière de la première surface ;
une première électrode (4) prévue sur la première surface du substrat (1) ; et
une deuxième électrode (5) prévue sur la deuxième surface du substrat (1) et comportant une deuxième partie d'extraction de sortie (5a) allongée,
où la deuxième partie d'extraction de sortie (5a) comprend une première ouverture (7a) au-dessous de la première électrode (4),
où une partie d'une périphérie de la première électrode (4) est disposée dans une projection orthogonale de la première électrode dans un plan parallèle à la deuxième surface dans la première ouverture (7a), et où
la première électrode (4) comprend une première partie d'extraction de sortie (4a) allongée,
le module de cellules solaires (10, 18) comportant en outre :
un premier conducteur interne (11) formé de manière à être allongé et relié à la première partie d'extraction de sortie (4a) le long d'un sens longitudinal (M) de la première partie d'extraction de sortie (4a), et
un deuxième conducteur interne (11) formé de manière à être allongé et relié à la deuxième partie d'extraction de sortie (5a) le long d'un sens longitudinal (M) de la deuxième partie d'extraction de sortie (5a),
où la première ouverture (7a) a une largeur (A) supérieure à une largeur (B) de la première partie d'extraction de sortie (4a) dans un sens latéral (N) de la première partie d'extraction de sortie (4a),
où la deuxième électrode (5) comprend une unité collectrice de courant (5b) formée sur presque la surface entière de la deuxième surface du substrat sauf dans une partie définissant une deuxième ouverture (7b) sur un côté arrière de la première partie d'extraction de sortie (4a),
où la deuxième partie d'extraction de sortie (5a) est formée sur et chevauche une partie de la deuxième unité collectrice de courant (5b),
où la deuxième ouverture (7b) est disposée dans une partie où la deuxième partie d'extraction de sortie (5a) est disposée, où
une largeur (F) de la deuxième ouverture (7b) est supérieure à la largeur (B) de la première partie d'extraction de sortie (4a), et
où une largeur (A) de la première ouverture est supérieure à une largeur (C) du deuxième conducteur interne.

2. Le module de cellules solaires selon la revendication 1,
dans lequel le premier conducteur interne (11) a une largeur (C') inférieure à une largeur (B) de la première partie d'extraction de sortie (4a) dans le sens latéral (N) de la première partie d'extraction de sortie (4a).

3. Le module de cellules solaires selon la revendication 1, dans lequel
une pluralité des premières ouvertures (7a) sont prévues avec intervalles (E) le long du sens longitudinal (M) de la deuxième partie d'extraction de sortie (5a), et
des longueurs (D) de la pluralité des premières ouvertures (7a) dans le sens longitudinal (M) de la deuxième partie d'extraction de sortie (5a) sont plus longues que les intervalles (E) parmi la pluralité des premières ouvertures (7a).

4. Le module de cellules solaires selon la revendication 1,
dans lequel une longueur (G) entre une surface latérale (5at) de la deuxième partie d'extraction de sortie (5a) et la première ouverture (7a) est inférieure à une largeur (A) de la première ouverture (7a) dans un sens latéral (N) de la deuxième partie d'extraction (5a).

5. Le module de cellules solaires selon la revendication 1,
dans lequel la deuxième électrode (5) comprend une troisième partie d'extraction de sortie (5c) ayant une largeur (H) inférieure à une longueur (G) entre la surface latérale (5at) de la deuxième partie d'extraction de sortie (5a) et la première ouverture (7a), et reliée à la deuxième partie d'extraction de sortie (5a).

6. Le module de cellules solaires selon la revendication 1,
dans lequel la deuxième partie d'extraction de sortie comprend une première partie et une deuxième partie disposée plus proche d'une périphérie du substrat que la première partie et ayant une largeur supérieur à celle de la première partie.

7. Le module de cellules solaires selon la revendication 1,
dans lequel la largeur (A) de la première ouverture (7a) est supérieure à la largeur (F) de la deuxième ouverture (7b) dans le sens latéral (N) de la première partie d'extraction de sortie (4a).

8. Le module de cellules solaires selon la revendication 1,
dans lequel la deuxième partie d'extraction de sortie (205a) comprend une troisième ouverture qui a une largeur supérieure à celle de la deuxième ouverture dans une région centrale du sens longitudinal de celle-ci.

9. Le module de cellules solaires selon la revendication 1,
dans lequel la deuxième partie d'extraction de sortie comprend une quatrième ouverture qui a une largeur inférieure à celle de la première ouverture sur un côté périphérique du substrat.

10. Le module de cellules solaires selon la revendication 1,
dans lequel le premier conducteur interne (11) est relié à la première partie d'extraction de sortie (4a) ou la deuxième partie d'extraction de sortie (5a) avec une soudure sans plomb.

11. Le module de cellules solaires selon la revendication 1, comportant en outre :
un film cristallin de silicium entre la première surface du substrat (1) et la première électrode (4).
